# EUROPEAN PATENT APPLICATION

(11) **EP 2 284 887 A2**
(43) Date of publication of application: **16.02.2011**
(21) Application number: 10170850.1
(22) Date of filing: 27.07.2010
(51) Int. Cl.: H01L 23/538, H01L 25/10

(54) **Module comprising semiconductor devices and module manufacturing method**

(30) Priority: 06.08.2009 JP 2009183103
(71) Applicant: Fujitsu Limited, Kawasaki-shi, Kanagawa 211-8588 (JP)
(72) Inventor: Takada, Rie, Kanagawa 211-8588 (JP)
(74) Representative: Lewin, David Nicholas

(57) **Abstract**

A semiconductor device module (150a) includes a first substrate layer (101a) on which a first semiconductor device (10a) is surface-mounted, a second substrate layer (101b) that is a layer laminated on a side of the first substrate layer (101a) on which the first semiconductor device (10a) is not surface-mounted, a second semiconductor device (10b) being surface-mounted on a surface of the second substrate layer (101b) and not on a side of the first substrate layer (101a), and a hollow section (102) that is a space sandwiched between the first substrate layer (101a) and the second substrate layer (101b) and formed on back sides of areas on which the first semiconductor device (10a) and the second semiconductor device (10b) are surface-mounted.

## Description

### FIELD

The embodiments discussed herein are directed to a semiconductor device module in which a semiconductor device including a solder ball or a flat electrode pad is mounted on a plane surface, an electronic circuit unit that includes the semiconductor device module, an electronic device that includes the semiconductor device module and/or the electronic circuit unit, and a method of manufacturing the semiconductor device module.

### BACKGROUND

In recent years, capacity and scale of integration of semiconductor devices, such as memories or control devices, have been increasing. In order to mount a semiconductor device with high capacity and high integration on a circuit substrate, it is common to mount semiconductor devices on two sides of the circuit substrate. The following conventional technology is disclosed with regard to two-side mounting of semiconductor devices.

For example, Japanese Laid-open Patent Publication No. 2008-277691 discloses a technology for mounting semiconductor devices on two sides of a circuit substrate by connecting a pair of an electrode section of a first electronic component and an electrode section of a second electronic component, the electronic components being opposed to each other with the circuit substrate interposed therebetween, by means of a conductive member integrally formed within a through-hole section formed on the circuit substrate.

Furthermore, Japanese Laid-open Patent Publication No. 2006-074031 discloses a technology, according to which a flexible substrate having semiconductor devices mounted on both edges of two sides thereof is folded so as to be arranged around the edge of a rigid substrate and along one or both sides of the rigid substrate. The rigid substrate, together with the folded flexible substrate, is inserted into a socket arranged on a circuit substrate.

Some semiconductor devices that have become available in recent years include solder balls or flat electrode pads, instead of leads, as electrodes for inputting/outputting signals to/from a circuit substrate and for receiving an electric supply from the circuit substrate. Solder balls and flat electrode pads are arranged on a contact surface of a semiconductor device so as to be in contact with a circuit substrate. The flat electrode pads are fixed to the circuit substrate by soldering or by pressure so that the semiconductor device is mounted on a flat surface of the circuit substrate. In this case, the problem described below occurs with regard to connection of the semiconductor device mounted on the flat surface.

Along with the increase in capacity and scale of integration, the volume ratio of silicon included in the semiconductor device is increased. Therefore, the coefficient of thermal expansion of a semiconductor device becomes close to the coefficient of thermal expansion of silicon. The coefficient of thermal expansion of silicon is lower than the coefficient of thermal expansion of a material of a circuit substrate that has a semiconductor device mounted on its flat surface. In a high-temperature atmosphere, a circuit substrate is deformed due to thermal expansion as the temperature becomes high, while a semiconductor device is hardly deformed.

If a semiconductor device is mounted on a flat surface of a circuit substrate by solder balls or flat electrode pads, the difference in deformation of the semiconductor device and the circuit substrate due to heat causes a decrease in reliability of the connection via the solder balls or flat electrode pads. Specifically, if a semiconductor device is mounted on a flat surface of a circuit substrate via solder balls or flat electrode pads, the semiconductor device retains its planar shape despite the heat, while the circuit substrate is warped or bent due to the heat. Thus, because a connection part that is connected via the solder balls or the flat electrode pads is stressed due to heat deformation of the circuit substrate, the connection condition between the semiconductor device and the circuit substrate becomes unstable; therefore, there is a possibility of disconnection of the connection part.

Accordingly, it is desirable to provide a semiconductor device module, an electronic circuit unit, an electronic device, and a method of manufacturing a semiconductor device module that improve the reliability of a connection part for surface-mounting of a semiconductor device.

### SUMMARY

According to an aspect of an embodiment of the invention, a semiconductor device module includes a first substrate layer on which a first semiconductor device is surface-mounted, a second substrate layer that is a layer laminated on a side of the first substrate layer on which the first semiconductor device is not surface-mounted, a second semiconductor device being surface-mounted on a surface of the second substrate layer and not on a side of the first substrate layer, and a hollow section that is a space sandwiched between the first substrate layer and the second substrate layer and formed on back sides of areas on which the first semiconductor device and the second semiconductor device are surface-mounted.

According to another aspect of an embodiment of the invention, an electronic circuit unit includes a semiconductor device module, and the semiconductor device module includes a first substrate layer on which a first semiconductor device is surface-mounted, a second substrate layer that is a layer laminated on a side of the first substrate layer on which the first semiconductor device is not surface-mounted, a second semiconductor device being surface-mounted on a surface of the second substrate layer and not on a side of the first substrate layer, and a hollow section that is a space sandwiched between the first substrate layer and the second substrate layer and formed on back sides of areas on which the first semiconductor device and the second semiconductor device are surface-mounted.

According to still another aspect of an embodiment of the invention, an electronic device includes a semiconductor device module, and the semiconductor device module includes a first substrate layer on which a first semiconductor device is surface-mounted, a second substrate layer that is a layer laminated on a side of the first substrate layer on which the first semiconductor device is not surface-mounted, a second semiconductor device being surface-mounted on a surface of the second substrate layer and not on a side of the first substrate layer, and a hollow section that is a space sandwiched between the first substrate layer and the second substrate layer and formed on back sides of areas on which the first semiconductor device and the second semiconductor device are surface-mounted.

According to still another aspect of an embodiment of the invention, a method of manufacturing a semiconductor device module includes: printing, on predetermined positions on a flexible substrate for each semiconductor device, a first mount section and a second mount section on which a first semiconductor device and a second semiconductor device are to be surface-mounted, respectively, a connection pad for connecting the semiconductor device to the circuit substrate, and a wiring pattern for connecting each of the first mount section and the second mount section to the connection pad; temporarily mounting the semiconductor device on the flexible substrate by fixing, to a supporting plate, the flexible substrate on which the wiring pattern is printed at the printing and by applying solder paste to the mount pad; attaching opposed areas of the flexible substrate at a position that is not a position where the semiconductor devices are opposed to each other after folding the flexible substrate at a fold line set between the semiconductor devices; fixing the semiconductor device that is mounted on the mount pad at the mounting by reflow soldering; and fixing attached areas of the flexible substrate that are attached at the attaching to the semiconductor device by folding the attached areas such that a connection surface of the connection land for connecting to the circuit substrate faces the circuit substrate, wherein the printing includes printing the connection land at a different distance from the mount pad for each of the semiconductor devices.

According to still another aspect of an embodiment of the invention, a method of manufacturing a mount component for mounting a semiconductor device on a circuit substrate, the semiconductor device being surface-mounted on two sides via a mount pad arranged in a grid pattern, the manufacturing method includes: printing, at predetermined positions on a rigid substrate for each semiconductor device, a mount pad for mounting the semiconductor device and a socket connection pattern for connecting the semiconductor device to a socket arranged on the circuit substrate; temporarily mounting the semiconductor device on the rigid substrate by fixing, to a supporting plate, the rigid substrate on which the socket connection pattern is printed at the printing and by applying solder paste to the mount pad; attaching opposed areas of the rigid substrate at a position that is not a position where the semiconductor devices are opposed to each other; and fixing the semiconductor device that is mounted on the mount pad at the mounting by reflow soldering.

According to still another aspect of an embodiment of the invention, a flexible substrate includes: a first mount section on which a first semiconductor device is surface-mounted and a second mount section on which a second semiconductor device is surface-mounted; a first connection land that has a connection surface for connecting the first semiconductor device to a circuit substrate and a second connection land that has a connection surface for connecting the second semiconductor device to the circuit substrate; and a first wiring pattern for connecting the first mount section to the first connection land and a second wiring pattern for connecting the second mount section to the second connection land, wherein the first mount section, the second mount section, the first connection land, the second connection land, the first wiring pattern, and the second wiring pattern are arranged on the same surface of the flexible substrate, and the first connection land and the second connection land are located at different distances from the first mount section and the second mount section, respectively.

### BRIEF DESCRIPTION OF DRAWINGS

FIGS. 1A and 1B are side views that illustrate the structure of a semiconductor device module according to a first embodiment;
FIGS. 2A to 2C are diagrams that illustrate the outer appearance of a flexible substrate of a BGA memory module according to a second embodiment;
FIGS. 3A to 3E are diagrams that illustrate an example of a process for manufacturing a BGA memory module according to the second embodiment;
FIG. 4 is a diagram that illustrates the structure of the BGA memory module according to the second embodiment as a side view;
FIG. 5A is a diagram that illustrates another example of the process for manufacturing the BGA memory module according to the second embodiment;
FIG. 5B is a diagram that illustrates another example of the process for manufacturing the BGA memory module according to the second embodiment;
FIG. 6 is a flowchart that illustrates the procedure for manufacturing the BGA memory module according to the second embodiment;
FIG. 7 is a diagram that illustrates an example of the arrangement of leads of a BGA memory;
FIGS. 8A to 8C are diagrams that illustrate the outer appearance of a flexible substrate of a BGA memory module according to a third embodiment;
FIGS. 9A to 9C are diagrams that illustrate an example of a process for manufacturing the BGA memory module according to the third embodiment;
FIGS. 9D to 9F are diagrams that illustrate an example of the process for manufacturing the BGA memory module according to the third embodiment;
FIG. 10 is a diagram that illustrates the structure of the BGA memory module according to the third embodiment as seen from a side view;
FIG. 11 is a diagram that illustrates the outer appearance of a flexible substrate of a BGA memory module according to a fourth embodiment;
FIGS. 12A to 12C are diagrams that illustrate an example of a process for manufacturing the BGA memory module according to the fourth embodiment;
FIGS. 12D to 12F are diagrams that illustrate an example of the process for manufacturing the BGA memory module according to the fourth embodiment;
FIGS. 13A to 13C are diagrams that illustrate the outer appearance of a BGA memory module according to a fifth embodiment;
FIGS. 14A to 14C are diagrams that illustrate the outer appearance of a BGA memory module according to a sixth embodiment;
FIGS. 14D and 14E are diagrams that illustrate the outer appearance of the BGA memory module according to the sixth embodiment; and
FIG. 15 is a flowchart that illustrates the procedure for manufacturing the BGA memory module according to the fifth embodiment and the sixth embodiment.

### DESCRIPTION OF EMBODIMENT(S)

Preferred embodiments of the present invention will be explained with reference to accompanying drawings. In the embodiments described below, an explanation is given using a Ball Grid Array (BGA) memory that uses a package called a BGA as an example of a semiconductor device.

The BGA is a package on which solder balls are arranged as leads for inputting/outputting signals in a grid pattern at regular intervals on the back side thereof. The BGA is a package suitable for high-density mounting of semiconductor devices. The BGA is a package in which solder balls are fixed to a mount pad for a semiconductor device by soldering so that the semiconductor device is mounted thereon.

The disclosed technology is applicable even if a semiconductor device includes a Land Grid Array (LGA) other than the BGA. On the LGA, flat electrode pads are arranged in a grid pattern at regular intervals instead of solder balls as on the BGA. The LGA is a package in which flat electrode pads are fixed to a mount pad for a semiconductor device by soldering or by a pressing force so that the semiconductor device is mounted thereon. A semiconductor device includes not only a memory but also an integrated circuit including a control circuit. That is, the technology disclosed in the present application is not limited to the embodiments described below.

### [a] First Embodiment

### Structure of a semiconductor device module

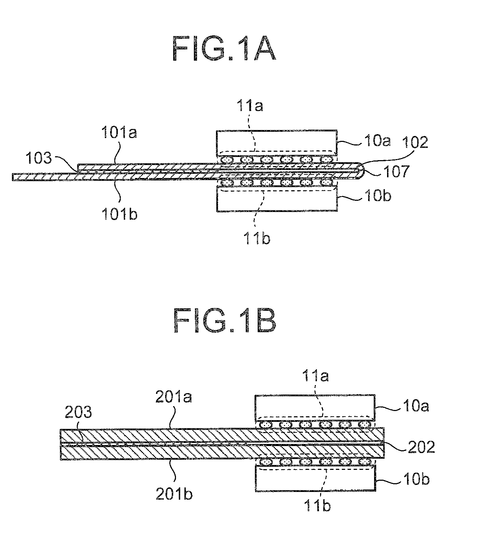

FIGS. 1A and 1B are side views that illustrate the structure of a semiconductor device module according to a first embodiment. FIG. 1A illustrates an example where a flexible substrate is used as a mount substrate that has semiconductor devices mounted on two sides thereof and that is to be mounted on a circuit substrate. FIG. 1B illustrates an example where rigid substrates are used as a mount substrate that has semiconductor devices mounted on two sides thereof and that is to be mounted on a circuit substrate.

According to FIG. 1A, a first semiconductor device 10a is mounted on a first substrate layer 101a of a mount substrate via solder balls 11a, and a second semiconductor device 10b is mounted on a second substrate layer 101b of the mount substrate via solder balls 11b. The first semiconductor device 10a and the second semiconductor device 10b are mounted on the surfaces of a first mount pad and a second mount pad (both not illustrated), respectively. As for the mount substrate, one flexible substrate is folded at a fold line 107 as the center so that the first substrate layer 101a and the second substrate layer 101b are formed.

A first connection land for connecting an input/output signal line of the first semiconductor device to a circuit substrate (not illustrated) is arranged on the surface of the first substrate layer 101a, on which the first semiconductor device 10a is mounted, near the end of the surface other than the end that is in the vicinity of the first mount pad. In the same manner, a second connection land for connecting an input/output signal line of the second semiconductor device to the above-described circuit substrate is arranged on the surface of the second substrate layer 101b, on which the second semiconductor device 10b is mounted, near the end of the surface other than the end that is in the vicinity of the second mount pad. A connection land is also called a footprint.

First printed wiring for connecting the first mount pad to the first connection land is printed on the surface of the first substrate layer 101a, on which the first semiconductor device 10a is mounted. In the same manner, second printed wiring for connecting the second mount pad to the second connection land is printed on the surface of the second substrate layer 101b, on which the second semiconductor device 10b is mounted.

As for the mount substrate, the length of the second substrate layer 101b from the fold line 107 is set to be longer than that of the first substrate layer 101a from the fold line 107. This is because the respective connection lands of the first semiconductor device 10a and the second semiconductor device 10b are prevented from overlapping with each other on the same area.

The mount substrate includes a hollow section 102 that is in the area sandwiched between the area of the first substrate layer 101a, corresponding to the back surface of the first mount pad, and the area of the second substrate layer 101b, corresponding to the back surface of the second mount pad. The mount substrate further includes an attached section 103 that is in the area sandwiched between an area that is not the area of the first substrate layer 101a corresponding to the back surface of the first mount pad and an area that is not the area of the second substrate layer 101b corresponding to the back surface of the second mount pad.

Specifically, for the mount substrate, the flexible substrate is folded at the fold line 107 as the center, and the back surfaces of the first substrate layer 101a and the second substrate layer 101b are attached to each other using an adhesive agent. The areas of the back surfaces that are attached to each other correspond to areas that are not the mount areas where the first semiconductor device 10a and the second semiconductor device 10b are surface-mounted. That is, the area sandwiched between the back surfaces corresponding to the mount areas, where the first semiconductor device 10a and the second semiconductor device 10b are surface-mounted, is the hollow section 102 that is not attached using an adhesive agent, and the area attached using an adhesive agent is the attached section 103.

In other words, the mount substrate includes the first substrate layer 101a on which the first semiconductor device 10a is surface-mounted; the second substrate layer 101b that is a layer laminated on the side of the first substrate layer 101a on which the first semiconductor device 10a is not surface-mounted, the second semiconductor device 10b being mounted on the surface of the second substrate layer 101b and not on the side of the first substrate layer 101a; and the hollow section 102 that is a space sandwiched between the first substrate layer 101a and the second substrate layer 101b and formed on the back sides of the areas where the first semiconductor device 10a and the second semiconductor device 10b are surface-mounted.

According to FIG. 1B, the first semiconductor device 10a is mounted on a first substrate layer 201a of a mount substrate via the solder balls 11a, and the second semiconductor device 10b is mounted on a second substrate layer 201b of the mount substrate via the solder balls 11b. The first semiconductor device 10a and the second semiconductor device 10b are mounted on the surfaces of a first mount pad and a second mount pad (both not illustrated), respectively. The first substrate layer 201a and the second substrate layer 201b of the mount substrate are formed by overlapping two rigid substrates having the same shape.

A first wiring pattern for connecting an input/output signal line of the first semiconductor device to a socket (not illustrated) of the circuit substrate is printed on the surface of the first substrate layer 201a, starting from the first mount pad and running to the vicinity of the end of the surface other than the end that is near the first mount pad. In the same manner, a second wiring pattern for connecting an input/output signal line of the second semiconductor device to a socket (not illustrated) of the circuit substrate is printed on the surface of the second substrate layer 201b, starting from the second mount pad and running to the vicinity of the end of the surface other than the end that is near the second mount pad.

The mount substrate includes a hollow section 202 that is in the area sandwiched between the area of the first substrate layer 201a, corresponding to the back surface of the first mount pad, and the area of the second substrate layer 201b, corresponding to the back surface of the second mount pad. The mount substrate further includes an attached section 203 that is in the area sandwiched between an area that is not the area of the first substrate layer 201a corresponding to the back surface of the first mount pad and an area that is not the area of the second substrate layer 201b corresponding to the back surface of the second mount pad.

Specifically, for the mount substrate, two rigid substrates having the same shape are overlapped with each other, and the back surfaces of the first substrate layer 201a and the second substrate layer 201b, which correspond to areas that are not the mount areas where the first semiconductor device 10a and the second semiconductor device 10b are surface-mounted, are attached to each other using an adhesive agent. That is, the area sandwiched between the back surfaces corresponding to the mount areas, where the first semiconductor device 10a and the second semiconductor device 10b are surface-mounted, is the hollow section 202 that is not attached using an adhesive agent, and the area attached using an adhesive agent is the attached section 203.

In other words, the mount substrate includes the first substrate layer 201a on which the first semiconductor device 10a is surface-mounted; the second substrate layer 201b, which is a layer laminated on the side of the first substrate layer 201a on which the first semiconductor device 10a is not surface-mounted, the second semiconductor device 10b being mounted on the surface of the second substrate layer 201b and not on the side of the first substrate layer 201a; and the hollow section 202, which is a space sandwiched between the first substrate layer 201a and the second substrate layer 201b and formed on the back sides of the areas where the first semiconductor device 10a and the second semiconductor device 10b are surface-mounted.

On the mount substrate, a cutout section may be arranged on the back sides of the areas where the first semiconductor device 10a and the second semiconductor device 10b are mounted on two sides. In this case, the hollow section 202 is formed to be larger because of the above-described cutout section so that it is possible to further reduce the effect of stress caused to the BGA memory due to heat deformation of the mount substrate.

A semiconductor device module that uses the flexible substrate illustrated in FIG. 1A is suitable for an apparatus, for example, a communication apparatus, or the like, in which semiconductor device modules are arranged in a spread manner near a control device that uses the semiconductor device modules. On the other hand, a semiconductor device module that uses the rigid substrates illustrated in FIG. 1B is suitable for an apparatus, for example, a computer device, such as a server or a personal computer, in which semiconductor device modules are arranged all together near a control device that uses the semiconductor device modules.

As illustrated in FIG. 1A, the hollow section 102 includes the area reaching up to the fold line 107 in the lamination formed by the first substrate layer 101a and the second substrate layer 101b. However, the present invention is not limited thereto, and the hollow section 102 only needs to include at least the substrate layers corresponding to the areas where the first semiconductor device 10a and the second semiconductor device 10b are mounted on two sides. Specifically, if the substrate layers do not correspond to the areas where the first semiconductor device 10a and the second semiconductor device 10b are mounted on two sides, the substrate layers from the first semiconductor device 10a and the second semiconductor device 10b to the fold line 107 may be attached to each other.

In a similar manner, as illustrated in FIG. 1B, the hollow section 202 includes the area reaching up to the ends of the substrate layers near the first semiconductor device 10a and the second semiconductor device 10b in the lamination formed by the first substrate layer 201a and the second substrate layer 201b. That is, the state is such that one end of the hollow section 202 is opened. However, the present invention is not limited thereto and, if the substrate layers do not correspond to the areas where the first semiconductor device 10a and the second semiconductor device 10b are mounted on two sides, the areas from the first semiconductor device 10a and the second semiconductor device 10b to the above-described ends of the substrate layers may be attached to each other.

As described above, according to the first embodiment, because the hollow section 102 and the hollow section 202 are formed in the mount substrates of the semiconductor devices, the thicknesses of the mount areas, on which the semiconductor devices are mounted, of the first substrate layer 101a and the second substrate layer 101b and the first substrate layer 201a and the second substrate layer 201b are reduced, whereby stress caused to each semiconductor device by the mount area of the substrate layer due to heat deformation can be reduced and therefore reliability of the connection between the semiconductor device and the substrate layer can be improved.

### [b] Second Embodiment

### Flexible substrate of a BGA memory module

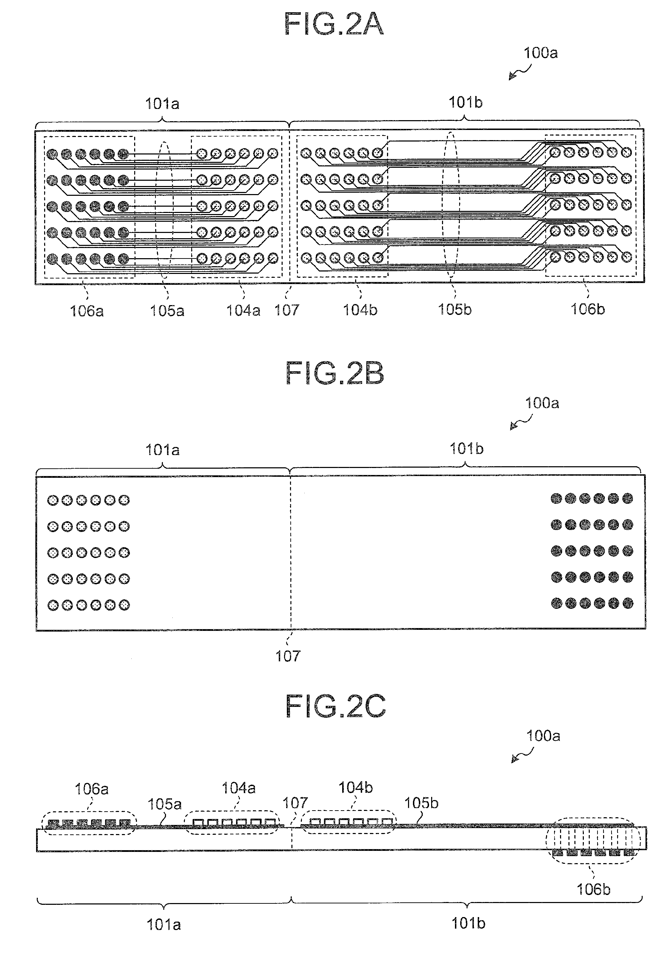

A case is explained according to a second embodiment in which the semiconductor device in the first embodiment is a BGA memory and the mount substrate is a flexible substrate. FIGS. 2A and 2B are diagrams that illustrate the outer appearance of a flexible substrate of a BGA memory module according to the second embodiment.

FIG. 2A is a top view of the flexible substrate of the BGA memory module according to the second embodiment. A flexible substrate 100a of the BGA memory module according to the second embodiment is a rectangular substrate that includes the first substrate layer 101a, where the first BGA memory 10a is surface-mounted, and the second substrate layer 101b, where the second BGA memory 10b is surface-mounted.

The first substrate layer 101a and the second substrate layer 101b are adjacent to each other with the fold line 107 as the boundary. As illustrated in FIG. 2A, the flexible substrate 100a is folded with the fold line 107 as the center, so that the surfaces on which the mount pads are mounted are outside, whereby the mount substrate is formed.

The first substrate layer 101a includes a first mount pad 104a where the BGA memory 10a is surface-mounted, a first connection land 106a for connecting the BGA memory 10a to a circuit substrate (not illustrated), and a first wiring pattern 105a for connecting respective leads of the first mount pad 104a and the first connection land 106a. The leads are indicated by circles in FIGS. 2A to 2C. The lead is a kind of terminal included in the first mount pad 104a and the first connection land 106a. The first mount pad 104a, the first wiring pattern 105a, and the first connection land 106a are printed using a well-known printing technology for circuit wiring patterns.

The second substrate layer 101b includes a second mount pad 104b where the BGA memory 10b is surface-mounted, a second connection land 106b for connecting the BGA memory 10b to a circuit substrate (not illustrated), and a second wiring pattern 105b for connecting respective leads of the second mount pad 104b and the second connection land 106b. The leads are indicated by circles in FIGS. 2A to 2C. The lead is a kind of terminal included in the second mount pad 104b and the second connection land 106b. The second mount pad 104b, the second wiring pattern 105b, and the second connection land 106b are printed using a well-known printing technology for circuit wiring patterns.

If the distance from the first mount pad 104a to the first connection land 106a is compared with the distance from the second mount pad 104b to the second connection land 106b, the distance from the second mount pad 104b to the second connection land 106b is set to be longer. This is because, if the flexible substrate 100a is folded at the fold line 107 as the center so that the surfaces on which mount pads are formed are outside, so as to form the mount substrate, the first connection land 106a and the second connection land 106b are prevented from overlapping with each other.

In FIG. 2A, the first BGA memory 10a is mounted on the surface of the first mount pad 104a of the flexible substrate 100a. In the top view of the flexible substrate 100a in FIG. 2A, because the connection surfaces of the leads of the first connection land 106a for connecting to the circuit substrate are arranged on the surface of the first substrate layer 101a, they are visible.

In FIG. 2A, the second BGA memory 10b is mounted on the surface of the second mount pad 104b of the flexible substrate 100a. In the top view of the flexible substrate 100a in FIG. 2A, because the connection surfaces of the leads of the second connection land 106b for connecting to the circuit substrate are arranged on the back surface of the second substrate layer 101b, they are not visible.

If the flexible substrate 100a is folded at the fold line 107 as the center so that the surfaces on which the mount pads are mounted are outside, the state is such that the first BGA memory 10a mounted on the surface of the first mount pad 104a and the second BGA memory 10b mounted on the surface of the second mount pad 104b are opposed to each other and mounted on two sides.

FIG. 2B is a bottom view of the flexible substrate of the BGA memory module according to the second embodiment. In the bottom view of the flexible substrate 100a in FIG. 2B, because the connection surfaces of the leads of the first connection land 106a for connecting to the circuit substrate are arranged on the surface of the first substrate layer 101a, they are not visible. In the bottom view of the flexible substrate 100a in FIG. 2B, because the connection surfaces of the leads of the second connection land 106b for connecting to the circuit substrate are arranged on the back surface of the second substrate layer 101b, they are visible.

FIG. 2C is a cross-sectional view of the flexible substrate of the BGA memory module according to the second embodiment. According to FIG. 2C, the first mount pad 104a, the first wiring pattern 105a, and the first connection land 106a are arranged on the top surface of the first substrate layer 101a. The first mount pad 104a is connected to the first connection land 106a by the first wiring pattern 105a. The first connection land 106a is faced upward so that it has the connection surface for connecting to the circuit substrate (not illustrated) on the top surface of the first substrate layer 101a.

According to FIG. 2C, the second mount pad 104b and the second wiring pattern 105b are arranged on the top surface of the second substrate layer 101b. The second connection land 106b is arranged on the lower surface of the second substrate layer 101b. One end of the second connection land 106b is exposed to the top surface of the second substrate layer 101b through through-holes. The exposed section is coupled to the second mount pad 104b by the second wiring pattern 105b. Thus, the second connection land 106b is faced downward so as to form a connection surface for connecting to the circuit substrate (not illustrated) on the lower surface of the second substrate layer 101b.

### Process for manufacturing a BGA memory module

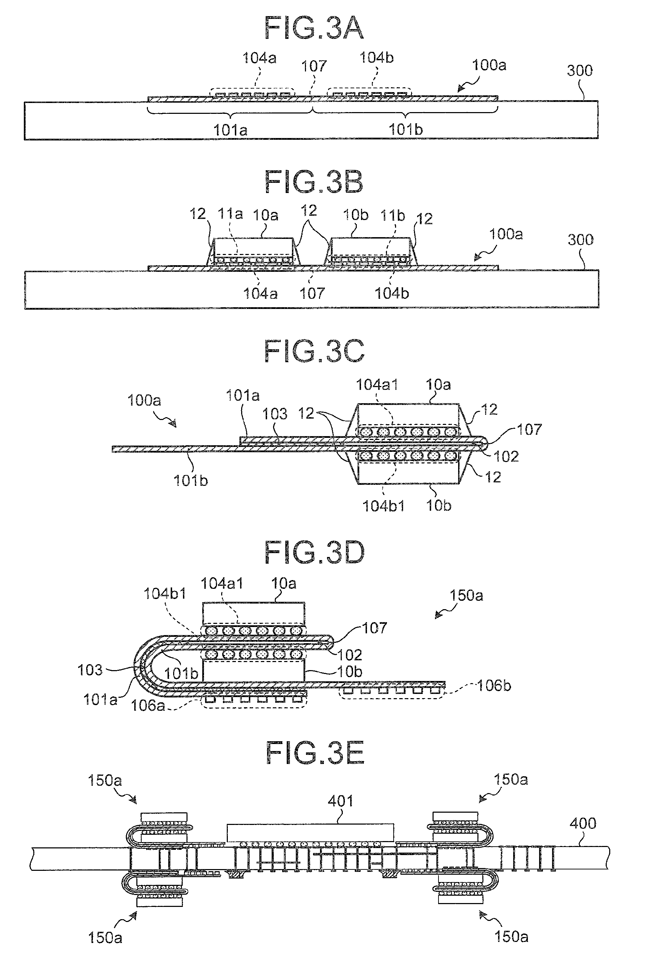

FIGS. 3A to 3E are diagrams that illustrate an example of a process for manufacturing a BGA memory module according to the second embodiment. In FIGS. 3A to 3E, a BGA memory module 150a according to the second embodiment is manufactured in the order illustrated in FIGS. 3A to 3E.

First, in FIG. 3A, the flexible substrate 100a is fixed to a supporting plate 300. The first mount pad 104a, the first wiring pattern 105a (not illustrated), and the first connection land 106a (not illustrated) are printed on the first substrate layer 101a of the flexible substrate 100a, and the second mount pad 104b, the second wiring pattern 105b (not illustrated), and the second connection land 106b (not illustrated) are printed on the second substrate layer 101b of the flexible substrate 100a.

Next, in FIG. 3B, the BGA memory 10a and the BGA memory 10b are mounted on the surfaces of the first mount pad 104a and the second mount pad 104b, respectively, on which solder paste is applied to each solder ball, and temporarily joined using temporary joint 12, such as an adhesive agent, as illustrated in FIG. 3B.

Next, in FIG. 3C, the flexible substrate 100a is folded using the fold line 107 as the center so that the BGA memory 10a and the BGA memory 10b are mounted on two sides. On the back surface of the folded flexible substrate 100a, the areas where the first substrate layer 101a and the second substrate layer 101b are in surface contact with each other, except for the areas where the BGA memory 10a and the BGA memory 10b are mounted on two sides, are attached to each other. The unattached area of the flexible substrate 100a is the hollow section 102, and the attached area is the attached section 103.

The BGA memory 10a and the BGA memory 10b, which are temporarily joined, are attached to the first mount pad 104a and the second mount pad 104b, respectively, by reflow soldering. The first mount pad 104a and the second mount pad 104b are joined to the leads of the BGA memory 10a and the BGA memory 10b, respectively, by reflow soldering. The first mount pad 104a and the second mount pad 104b, which are joined to respective leads of the BGA memory 10a and the BGA memory 10b, are referred to as a first connection section 104a1 and a second connection section 104b1, respectively. Afterward, the temporary joint 12 is removed.

Next, in FIG. 3D, the area including the attached section 103 of the first substrate layer 101a and the second substrate layer 101b is folded toward the second BGA memory 10b. Then, the second BGA memory 10b is attached to the opposing second substrate layer 101b so that the BGA memory module 150a is completed. At this time, as illustrated in FIG. 3D, the connection surfaces of the first connection land 106a and the second connection land 106b for connecting to the circuit substrate (not illustrated) are both faced downward.

As illustrated in FIG. 3E, the BGA memory modules 150a are arranged in a spread manner near a control semiconductor device 401 mounted on a circuit substrate 400. The BGA memory module 150a is connected to the circuit substrate 400 using a method such as attachment by soldering. The BGA memory module 150a is fixed to the circuit substrate 400 using an adhesive agent or tape.

### Side view of a BGA memory module

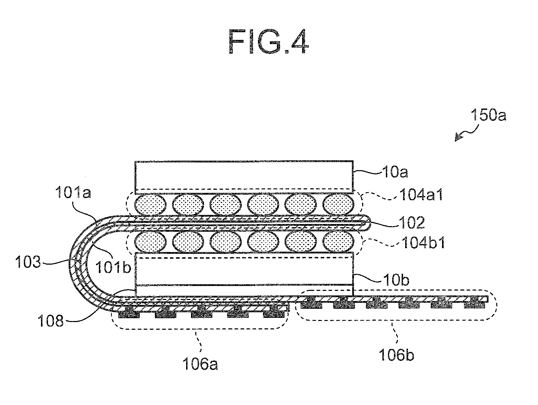

FIG. 4 is a diagram that illustrates the structure of the BGA memory module according to the second embodiment as a side view. According to FIG. 4, the BGA memory module 150a is formed by stacking, from the top, the first BGA memory 10a, the first connection section 104a1, the first substrate layer 101a, the hollow section 102, the second substrate layer 101b, the second connection section 104b1, the second BGA memory 10b, an attachment section 108 for the second BGA memory 10b and the second substrate layer 101b, the second connection land 106b with the second substrate layer 101b, and the first connection land 106a with the first substrate layer 101a.

The first substrate layer 101a and the second substrate layer 101b are folded toward the second BGA memory 10b at the first connection section 104a1 and the second connection section 104b1. The attached section 103 is located between the first substrate layer 101a and the second substrate layer 101b including the folded areas.

In other words, the BGA memory module 150a includes the first substrate layer 101a on which the first BGA memory 10a is surface-mounted; the second substrate layer 101b, which is a layer laminated on the side of the first substrate layer 101a on which the first BGA memory 10a is not surface-mounted, the second BGA memory 10b being mounted on the surface of the second substrate layer 101b and not on the side of the first substrate layer 101a; and the hollow section 102, which is a space sandwiched between the first substrate layer 101a and the second substrate layer 101b and formed on the back sides of the areas where the first BGA memory 10a and the second BGA memory 10b are surface-mounted.

In FIGS. 3D and 4, the second substrate layer 101b may be fixed to the second BGA memory 10b such that the first connection land 106a is located near a position just under the second BGA memory, and the length of the second substrate layer 101b may be set such that the second connection land 106b is located closer to the first connection land 106a. In this manner, the area for mounting the BGA memory module 150a to the circuit substrate can be reduced.

### Another example of the process for manufacturing a BGA memory module

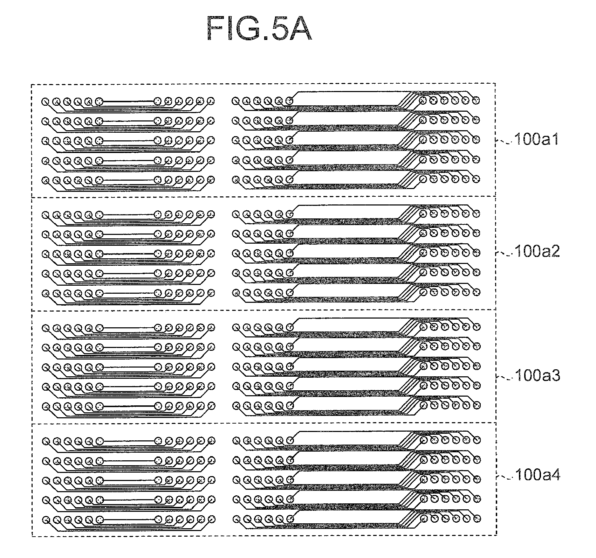

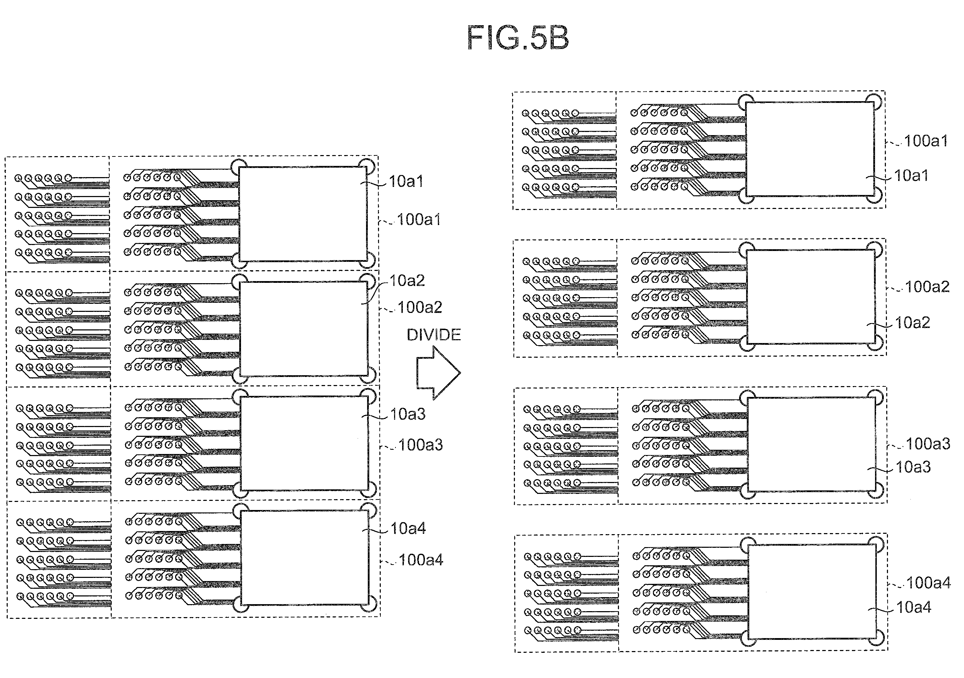

FIGS. 5A and 5B are diagrams that illustrate another example of the process for manufacturing the BGA memory module according to the second embodiment. Specifically, patterns for flexible substrates with the same specification, each including a mount pad, a wiring pattern, and a connection land, are printed on one flexible substrate.

Then, the manufacturing process corresponding to FIGS. 3A to 3C is performed on the flexible substrates (four flexible substrates 100a1 to 100a4 in FIGS. 5A and 5B) that have the patterns with the same specification printed on them. Specifically, after the manufacturing process in FIG. 3C, the flexible substrates (not illustrated) of the BGA memory modules where first BGA memories 10a1 to 10a4 and second BGA memories 10b1 to 10b4 are surface-mounted are produced as illustrated in the left section of FIG. 5B. Then, as illustrated in the right section of FIG. 5B, the flexible substrates 100a1 to 100a4 are separated from one another, and the manufacturing process illustrated in FIGS. 3D and 3E is performed on each of the flexible substrates.

As described above, if the process for manufacturing a BGA memory module illustrated in FIGS. 3A to 3C is performed on a plurality of flexible substrates that are combined together, the efficiency for manufacturing a BGA memory module can be improved and the manufacturing costs can be reduced.

### Procedure for manufacturing a BGA memory module

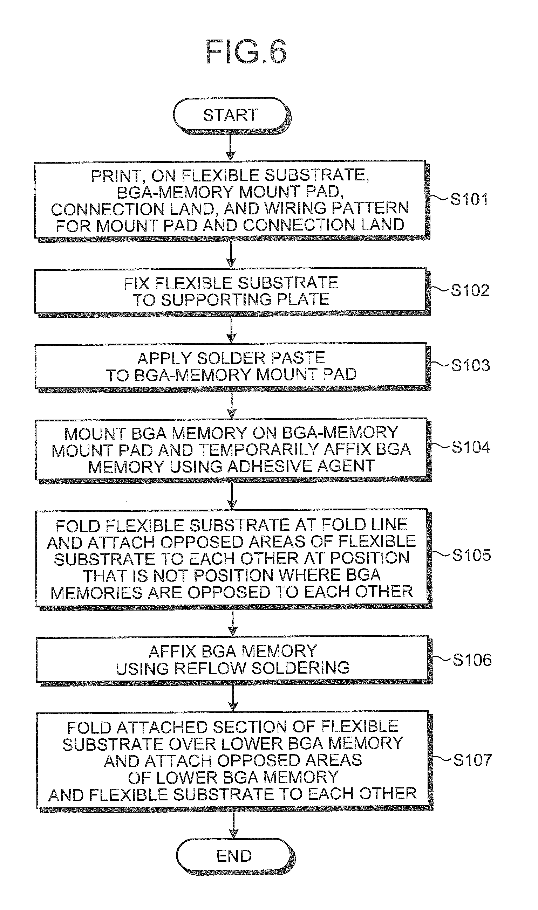

FIG. 6 is a flowchart that illustrates the procedure for manufacturing the BGA memory module according to the second embodiment. The flowchart illustrates the procedure performed by, for example, an apparatus for manufacturing a BGA memory module. It may be manually performed.

First, a mount pad for a BGA memory, a connection land for connecting to a circuit substrate, and a wiring pattern between the mount pad and the connection land are printed on a flexible substrate (Step S101). Then, the flexible substrate, on which the mount pad, the connection land, and the wiring pattern have been printed at Step S101, is fixed to a supporting plate (Step S102).

Then, solder paste is applied to the mount pad for a BGA memory (Step S103). A BGA memory is then mounted on the mount pad for a BGA memory and temporarily affixed using an adhesive agent (Step S104).

The flexible substrate is then folded at the fold line, and the opposed areas of the flexible substrate at a position that is not the position where the BGA memories are opposed to each other are attached to each other (Step S105). Then, the BGA memories are subjected to reflow soldering (Step S106). The attached section of the flexible substrate is folded over the lower BGA memory (for example, the BGA memory 10b illustrated in FIG. 4), and the opposed areas of the lower BGA memory and the flexible substrate are attached to each other (Step S107).

As described above, according to the second embodiment, the BGA memories are surface-mounted on two sides using the flexible substrate, and the hollow section is formed within the substrate layers of the flexible substrate corresponding to the areas where the BGA memories are surface-mounted; therefore, it is possible to provide a BGA memory module with a highly reliable surface-mounting connection for a BGA memory even at a high temperature. Further, because the first connection land 106a and the second connection land 106b are separated from each other, a process for manufacturing a BGA memory module is facilitated.

### [c] Third Embodiment

### Example of arrangement of leads of a BGA memory

A third embodiment is an embodiment where, for the first connection land 106a and the second connection land 106b of the BGA memory module 150a according to the second embodiment, a common connection land is shared by leads used for ground or earth that are included in the leads of the BGA memory 10a and the BGA memory 10b. An explanation is given only of the parts that are different between the third embodiment and the second embodiment.

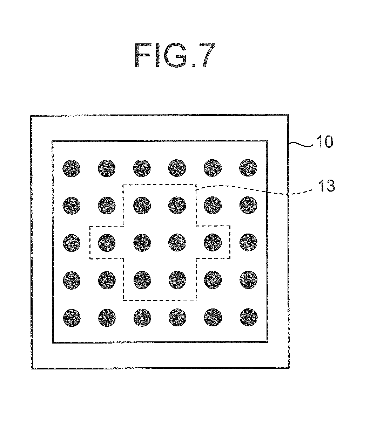

FIG. 7 is a diagram that illustrates an example of the arrangement of leads of a BGA memory. A BGA memory 10 includes, on the back surface thereof, a plurality of leads that are for surface mounting to a circuit substrate. For example, the leads that are included in the leads indicated by the circles in FIG. 7 and surrounded by the broken line constitute a ground section 13. According to the third embodiment, a common connection land is shared by the ground sections 13 of two BGA memories mounted on two sides so that the entire area of the connection land is reduced and a BGA memory module can be mounted on a circuit substrate in a more compact manner.

### Flexible substrate of a BGA memory module

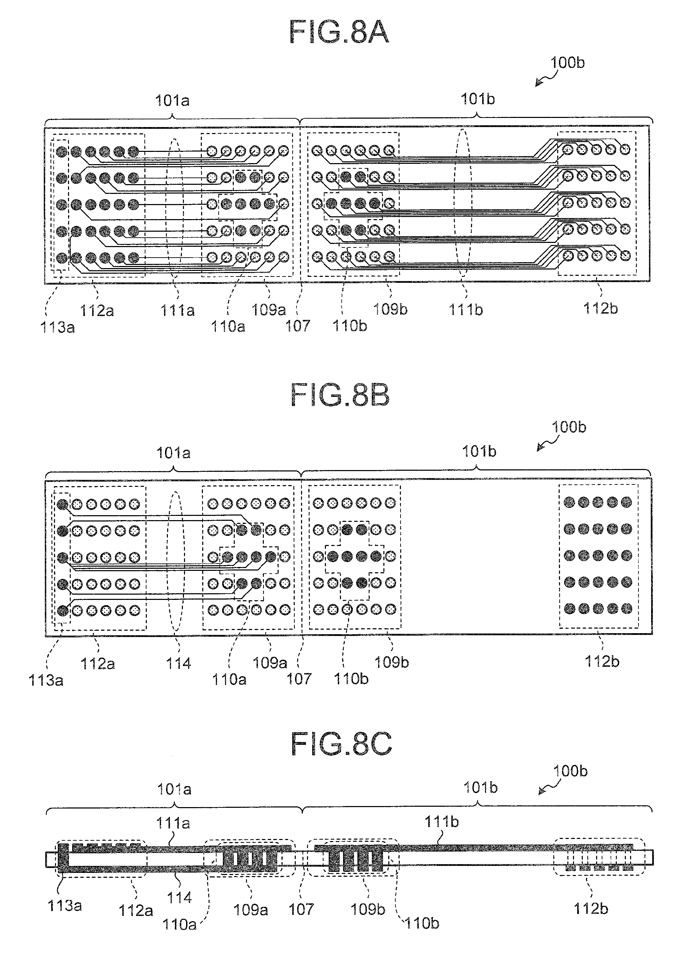

FIGS. 8A to 8C are diagrams that illustrate the outer appearance of a flexible substrate of a BGA memory module according to the third embodiment. FIG. 8A is a top view of the flexible substrate of the BGA memory module according to the third embodiment. A flexible substrate 100b of the BGA memory module according to the third embodiment is a rectangular substrate that includes the first substrate layer 101a where the first BGA memory 10a is surface-mounted and the second substrate layer 101b where the second BGA memory 10b is surface-mounted.

The first substrate layer 101a includes a first mount pad 109a where the BGA memory 10a is surface-mounted, a first connection land 112a for connecting the BGA memory 10a to a circuit substrate (not illustrated), and a first wiring pattern 111a for connecting respective leads of the first mount pad 109a and the first connection land 112a.

The first mount pad 109a includes a first ground section 110a. The first connection land 112a includes a ground land 113a. The ground land is a connection land for connecting a ground section of the BGA memory 10 to a ground section of the circuit substrate (not illustrated). The leads of the first mount pad 109a, except for the leads of the first ground section 110a, are connected to the leads of the first connection land 112a, except for the leads of the ground land 113a.

The second substrate layer 101b includes a second mount pad 109b where the BGA memory 10b is surface-mounted, a second connection land 112b for connecting the BGA memory 10b to a circuit substrate (not illustrated), and a second wiring pattern 111b for connecting respective leads of the second mount pad 109b and the second connection land 112b.

The second mount pad 109b includes a second ground section 110b. The second connection land 112b does not include any ground land and has fewer leads than those of the second mount pad 109b. This is because, if the flexible substrate 100b is folded at the fold line 107 as the center so that the top surfaces of the first substrate layer 101a and the second substrate layer 101b face outward so as to form the mount substrate, the first ground section 110a of the first mount pad 109a is connected to the second ground section 110b of the second mount pad 109b and the ground land 113a is shared by the second ground section 110b and the first ground section 110a.

In FIG. 8A, the first BGA memory 10a is mounted on the surface of the first mount pad 109a of the flexible substrate 100b. In the top view of the flexible substrate 100b in FIG. 8A, because the connection surfaces of the leads of the first connection land 112a for connecting to the circuit substrate are arranged on the surface of the first substrate layer 101a, they are visible.

In FIG. 8A, the second BGA memory 10b is mounted on the surface of the second mount pad 109b of the flexible substrate 100b. In the top view of the flexible substrate 100b in FIG. 8A, because the connection surfaces of the leads of the second connection land 112b for connecting to the circuit substrate are arranged on the back surface of the second substrate layer 101b, they are not visible.

If the flexible substrate 100b is folded at the fold line 107 as the center so that the top surfaces of the first substrate layer 101a and the second substrate layer 101b face outward, the state is such that the first BGA memory 10a mounted on the surface of the first mount pad 109a and the second BGA memory 10b mounted on the surface of the second mount pad 109b are opposed to each other and mounted on two sides.

FIG. 8B is a bottom view of the flexible substrate of the BGA memory module according to the third embodiment.

In the bottom view of the flexible substrate 100b in FIG. 8B, because the connection surfaces of the leads of the first connection land 112a for connecting to the circuit substrate are arranged on the surface of the first substrate layer 101a, they are not visible. In the bottom view of the flexible substrate 100b in FIG. 8B, because the connection surfaces of the leads of the second connection land 112b for connecting to the circuit substrate are arranged on the back surface of the second substrate layer 101b, they are visible. In FIG. 8B, the leads of the first ground section 110a are connected to the leads of the ground land 113a, respectively, by a wiring pattern 114.

FIG. 8C is a cross-sectional view of the flexible substrate of the BGA memory module according to the third embodiment. According to FIG. 8C, the first mount pad 109a, the first wiring pattern 111a, and the first connection land 112a are arranged on the top surface of the first substrate layer 101a. The first mount pad 109a is connected to a part of the first connection land 112a, except the ground land 113a, by the first wiring pattern 111a. The first connection land 112a is faced upward so that it has the connection surface for connecting to the circuit substrate (not illustrated) on the top surface of the first substrate layer 101a.

According to FIG. 8C, the first ground section 110a, the wiring pattern 114, and the ground land 113a are arranged on the lower surface of the first substrate layer 101a. Specifically, the first ground section 110a reaches the lower surface of the first substrate layer 101a from the top surface thereof via through-holes of the first substrate layer 101a and is coupled to the ground land 113a via the wiring pattern 114 on the lower surface of the first substrate layer 101a. The ground land 113a reaches the top surface of the first substrate layer 101a from the lower surface thereof via through-holes of the first substrate layer 101a.

According to FIG. 8C, the second mount pad 109b and the second wiring pattern 111b are arranged on the top surface of the second substrate layer 101b. The second connection land 112b is arranged on the lower surface of the second substrate layer 101b. One end of the second connection land 112b is exposed to the top surface of the second substrate layer 101b via through-holes. The exposed section is connected to the second mount pad 109b by the second wiring pattern 111b.

Specifically, the second connection land 112b is faced downward and has the connection surface for connecting to a circuit substrate (not illustrated) on the lower surface of the second substrate layer 101b. If the flexible substrate 100b is folded at the fold line 107 as the center so that the top surfaces of the first substrate layer 101a and the second substrate layer 101b face outward, the first ground section 110a is connected to the second ground section 110b so that the ground leads of the second BGA memory 10b mounted on the surface of the second mount pad 109b are connected to the ground land 113a via the second ground section 110b and the first ground section 110a.

### Process for manufacturing a BGA memory module

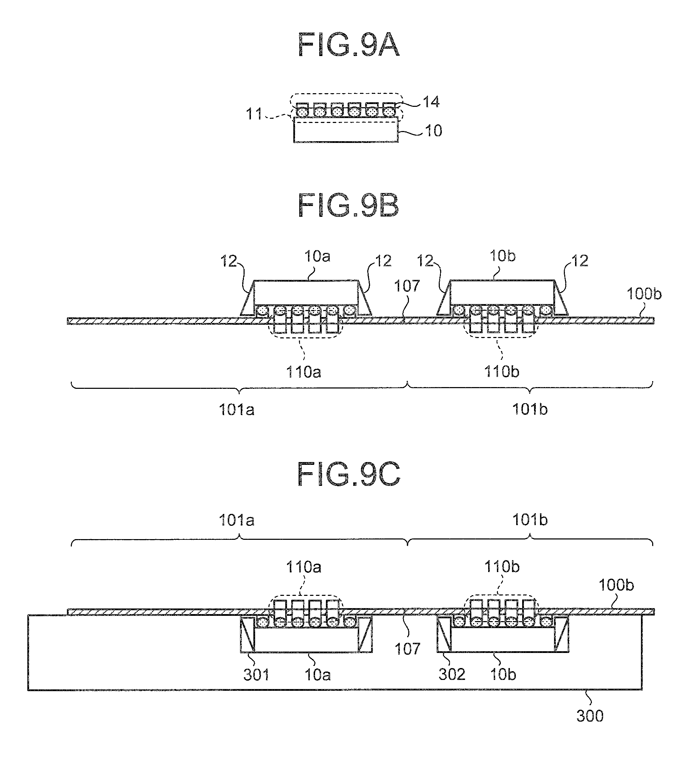

FIGS. 9A to 9F are diagrams that illustrate an example of a process for manufacturing the BGA memory module according to the third embodiment. In FIGS. 9A to 9F, a BGA memory module 150b according to the third embodiment is manufactured in the order illustrated in FIGS. 9A to 9E.

First, solder paste 14 is applied to the solder balls 11 (the solder ball 11a and the solder ball 11b) of the BGA memory 10 (the BGA memory 10a and the BGA memory 10b) in FIG. 9A.

Next, in FIG. 9B, the BGA memory 10a and the BGA memory 10b are mounted on the surfaces of the first mount pad 109a and the second mount pad 109b, on which the solder paste 14 is applied to each lead, and temporarily joined by the temporary joint 12, such as an adhesive agent, as illustrated in FIG. 9B.

Next, in FIG. 9C, the flexible substrate 100b is reversed and fixed to the supporting plate 300 that includes a recessed portion 301 and a recessed portion 302. At this time, the BGA memory 10a and the BGA memory 10b, which are temporarily joined using the temporary joint 12, are fitted into the recessed portion 301 and the recessed portion 302, respectively.

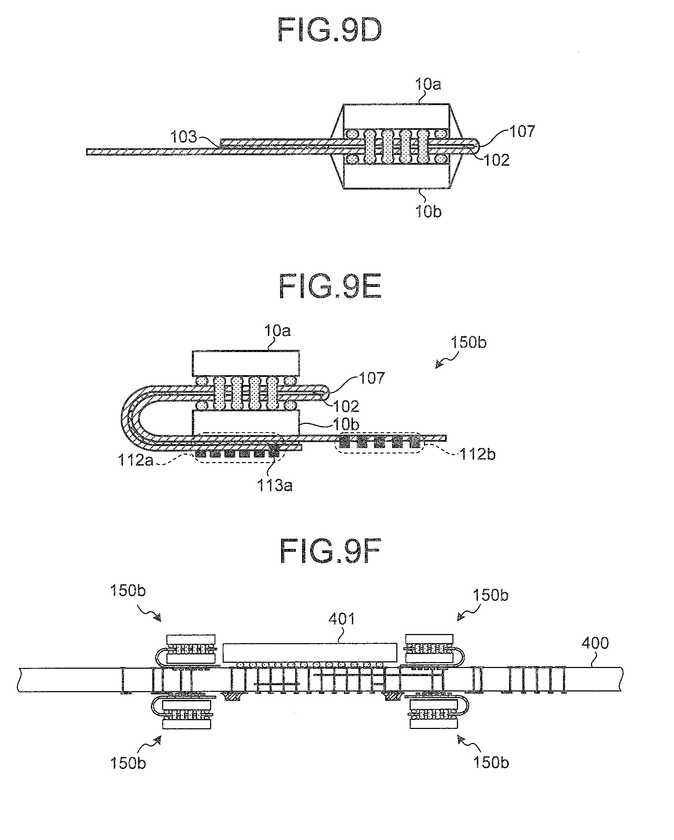

Next, in FIG. 9D, the flexible substrate 100b is folded using the fold line 107 as the center such that the BGA memory 10a and the BGA memory 10b are mounted on two sides. On the back surface of the folded flexible substrate 100b, the areas where the first substrate layer 101a and the second substrate layer 101b are in surface contact with each other, except for the areas where the BGA memory 10a and the BGA memory 10b are mounted on two sides, are attached to each other. The unattached area of the flexible substrate 100b is the hollow section 102, and the attached area is the attached section 103. At this time, the first ground section 110a and the second ground section 110b illustrated in FIG. 9C are connected to each other by soldering, or the like, so as to be joined to each other.

Next, in FIG. 9E, the area including the attached section 103 of the first substrate layer 101a and the second substrate layer 101b is folded toward the second BGA memory 10b. Then, the second BGA memory 10b is attached to the opposing second substrate layer 101b so that the BGA memory module 150b is completed. At this time, as illustrated in FIG. 9E, the connection surfaces of the first connection land 112a including the ground land 113a and the second connection land 112b for connecting to the circuit substrate (not illustrated) are both faced downward.

As illustrated in FIG. 9F, the BGA memory modules 150b are arranged in a spread manner near the control semiconductor device 401 mounted on the circuit substrate 400. The BGA memory module 150b is connected to the circuit substrate 400 using a method such as attachment by soldering or an adhesive agent.

### Side view of a BGA memory module

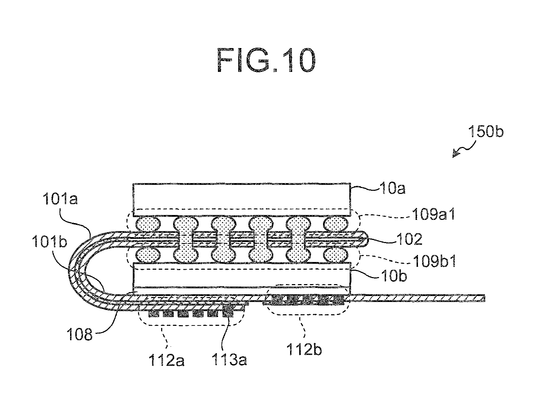

FIG. 10 is a diagram that illustrates the structure of the BGA memory module according to the third embodiment as a side view. According to FIG. 10, the BGA memory module 150b is formed by stacking, from the top, the first BGA memory 10a, a first connection section 109a1, the first substrate layer 101a, the hollow section 102, the second substrate layer 101b, a second connection section 109b1, the second BGA memory 10b, an attachment section 108 for the second BGA memory 10b and the second substrate layer 101b, the second connection land 112b with the second substrate layer 101b, and the first connection land 112a including the ground land 113a with the first substrate layer 101a.

In other words, the BGA memory module 150b includes the first substrate layer 101a on which the first BGA memory 10a is surface-mounted; the second substrate layer 101b, which is a layer laminated on the side of the first substrate layer 101a on which the first BGA memory 10a is not surface-mounted, the second BGA memory 10b being mounted on the surface of the second substrate layer 101b and not on the side of the first substrate layer 101a; and the hollow section 102, which is a space sandwiched between the first substrate layer 101a and the second substrate layer 101b and formed on the back sides of the areas where the first BGA memory 10a and the second BGA memory 10b are surface-mounted.

As described above, according to the third embodiment, the BGA memories are surface-mounted on two sides using the flexible substrate, the hollow section is formed within the substrate layers of the flexible substrate corresponding to the areas where the BGA memories are surface-mounted, and the ground land, which is used for grounding, included in the connection lands is shared by two BGA memories mounted on two sides, whereby the area for mounting a BGA memory module on a circuit substrate can be reduced, and an electronic circuit unit or an electronic device on which a BGA memory module is mounted can be compact.

### [d] Fourth Embodiment

### Flexible substrate of a BGA memory module

A case is explained according to a fourth embodiment in which, in addition to the main mount pads, auxiliary mount pads are arranged as mount pads for two BGA memories mounted on the surface of a flexible substrate 100c according to the second embodiment. An explanation is given only of the parts that are different between the fourth embodiment and the second embodiment.

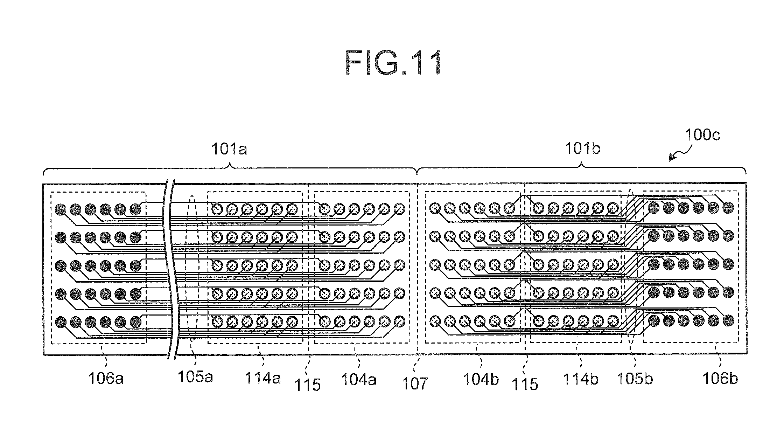

FIG. 11 is a diagram that illustrates the outer appearance of a flexible substrate of a BGA memory module according to the fourth embodiment. A first auxiliary mount pad 114a is arranged adjacent to the first mount pad 104a on the surface of the first substrate layer 101a of the flexible substrate 100c according to the fourth embodiment, as illustrated in FIG. 11.

Further, a second auxiliary mount pad 114b is arranged adjacent to the second mount pad 104b on the surface of the second substrate layer 101b, as illustrated in FIG. 11.

The first auxiliary mount pad 114a and the second auxiliary mount pad 114b are connected to the first connection land 106a and the second connection land 106b, via the wiring pattern 105a and the wiring pattern 105b, respectively, in the same manner as the first mount pad 104a and the second mount pad 104b.

The first auxiliary mount pad 114a and the second auxiliary mount pad 114b are used if a problem occurs in the connection for the surface mounting of the BGA memory 10a and/or the BGA memory 10b mounted on two sides of the first mount pad 104a and the second mount pad 104b. Specifically, the BGA memory 10a and the BGA memory 10b mounted on two sides of the first mount pad 104a and the second mount pad 104b are cut off at a cutoff line 115 together with the flexible substrate, and the new BGA memory 10a and the new BGA memory 10b are mounted on two sides of the first auxiliary mount pad 114a and the second auxiliary mount pad 114b.

### Process for manufacturing a BGA memory module

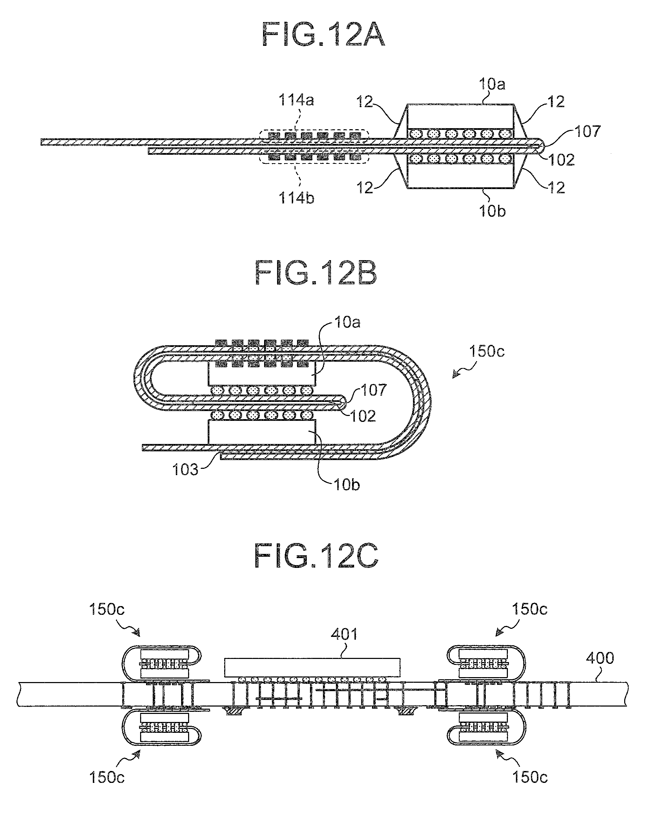

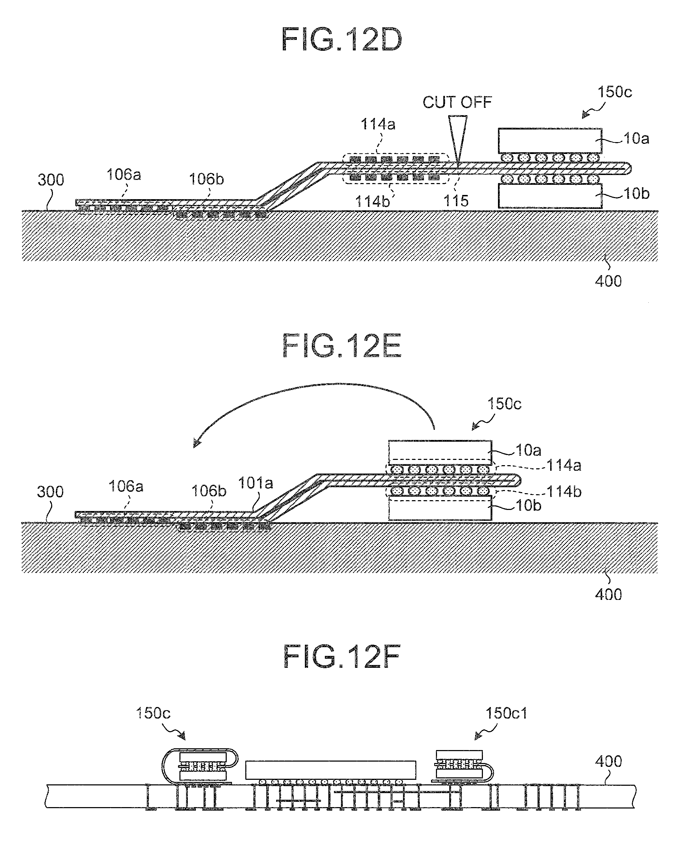

FIGS. 12A to 12F are diagrams that illustrate an example of the process for manufacturing a BGA memory module according to the fourth embodiment. In FIGS. 12A to 12F, a BGA memory module 150c according to the fourth embodiment is manufactured in the order illustrated in FIGS. 12A to 12F.

First, in FIG. 12A, the flexible substrate 100c is folded at the fold line 107 as the center so that the BGA memory 10a and the BGA memory 10b, which are temporarily joined using the temporary joint 12, are mounted on two sides. On the back surface of the folded flexible substrate 100c, the areas where the first substrate layer 101a and the second substrate layer 101b are in surface contact with each other, except for the areas where the BGA memory 10a and the BGA memory 10b are mounted on two sides, are attached to each other. The unattached area of the flexible substrate 100c is the hollow section 102, and the attached area is the attached section 103.

The BGA memory 10a and the BGA memory 10b, which are temporarily joined, are attached to the first mount pad 104a and the second mount pad 104b, respectively, by reflow soldering. The first mount pad 104a and the second mount pad 104b are joined to the leads of the BGA memory 10a and the BGA memory 10b, respectively, by reflow soldering. Afterward, the temporary joint 12 is removed.

Next, in FIG. 12B, the area including the attached section 103 of the first substrate layer 101a and the second substrate layer 101b is folded toward the first BGA memory 10a. Then, the first BGA memory 10a is attached to the opposing second substrate layer 101b. Further, the rest of the substrate layers is folded toward the second BGA memory 10b and fixed thereto so that the BGA memory module 150c is completed.

Then, as illustrated in FIG. 12C, the BGA memory modules 150c are arranged in a spread manner near the control semiconductor device 401 mounted on the circuit substrate 400. The BGA memory module 150c is connected to the circuit substrate 400 using a method such as attachment by soldering or using an adhesive agent.

Next, if a problem occurs with the surface mounting of the first BGA memory 10a and/or the second BGA memory 10b, as illustrated in FIG. 12D, the attached areas of the first substrate layer 101a and the second substrate layer 101b with the first BGA memory 10a and the second BGA memory 10b are released. In this case, the connection of the first connection land 106a and the second connection land 106b with the circuit substrate 400 is maintained.

The first BGA memory 10a and the second BGA memory 10b mounted on the first mount pad 104a and the second mount pad 104b are cut off at the cutoff line together with the substrate layers.

Next, as illustrated in FIG. 12E, a new first BGA memory 10a and a new second BGA memory 10b are mounted on the surfaces of the first auxiliary mount pad 114a and the second auxiliary mount pad 114b, respectively. Then, the first BGA memory 10a and the second BGA memory 10b are folded in the direction of the arrow in FIG. 12E, and the jointing surfaces of the first BGA memory 10a and the first substrate layer 101a are attached to each other. After the process of FIGS. 12D to 12F described above, a BGA memory module 150c1, which is produced by reworking the BGA memory module 150c according to the third embodiment, is completed.

As described above, according to the fourth embodiment, the BGA memories are surface-mounted on two sides using the flexible substrate, the hollow section is formed within the substrate layers of the flexible substrate corresponding to the areas where the BGA memories are surface-mounted, and the flexible substrate includes the auxiliary mount pad; therefore, it is possible to provide a BGA memory module for which reworking is facilitated.

### [e] Fifth Embodiment

### Rigid substrate of a BGA memory module

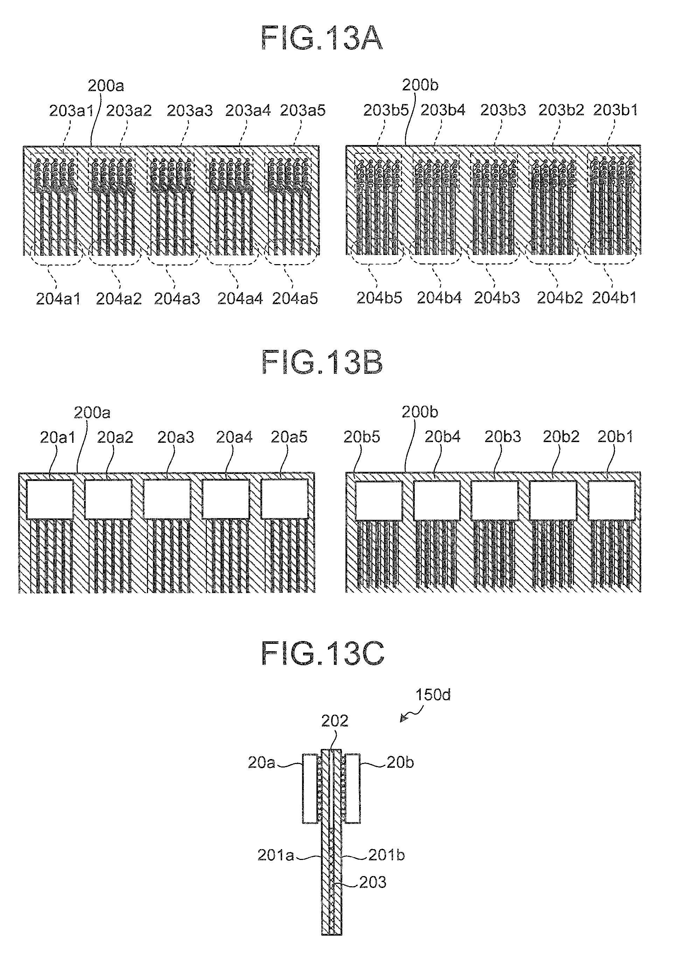

A case is explained according to a fifth embodiment in which the semiconductor device in the first embodiment is a BGA memory and the mount substrate is a rigid substrate. FIGS. 13A to 13C are diagrams that illustrate the outer appearance of a rigid substrate of a BGA memory module according to the fifth embodiment.

FIG. 13A is a top view of a rigid substrate of a BGA memory module according to the fifth embodiment. The rigid substrate of the BGA memory module according to the fifth embodiment is made up of a first rigid substrate 200a where a first BGA memory 20a is surface-mounted and a second rigid substrate 200b where a second BGA memory 20b is surface-mounted. The first rigid substrate 200a and the second rigid substrate 200b are identical rectangular substrates. A BGA memory module 150d according to the fifth embodiment is formed by sticking the first rigid substrate 200a and the second rigid substrate 200b together.

As illustrated in FIG. 13A, the first rigid substrate 200a includes a plurality of mount pads 203a1 to 203a5. The second rigid substrate 200b includes a plurality of mount pads 203b1 to 203b5. Wiring patterns 204a1 to 204a5 and 204b1 to 204b5 extend from the mount pads 203a1 to 203a5 and 203b1 to 203b5 to the lower sides of their respective substrate layers.

As illustrated in FIG. 13B, BGA memories 20a1 to 20a5 and 20b1 to 20b5 are mounted on the surfaces of the mount pads 203a1 to 203a5 and 203b1 to 203b5, respectively.

As illustrated in the side view of the BGA memory module 150d in FIG. 13C, the first rigid substrate 200a and the second rigid substrate 200b are affixed to each other such that the BGA memories 20a1 to 20a5 and the BGA memories 20b1 to 20b5 are opposed to each other and mounted on two sides. The first rigid substrate 200a corresponds to the first substrate layer 201a, and the second rigid substrate 200b corresponds to the second substrate layer 201b.

If the first rigid substrate 200a and the second rigid substrate 200b are affixed to each other, the areas of the first rigid substrate 200a and the second rigid substrate 200b, which correspond to the areas where the BGA memory 20a and the BGA memory 20b are mounted on two sides, are not attached to each other. Only the areas corresponding to areas that are not the areas where the BGA memory 20a and the BGA memory 20b are mounted on two sides are attached to each other. Thus, the hollow section 202 and the attached section 203 are formed.

In other words, the BGA memory module 150d includes the first substrate layer 201a on which the first BGA memories 20a1 to 20a5 are surface-mounted; the second substrate layer 201b, which is a layer laminated on the side of the first substrate layer 201a on which the first BGA memory 20a is not surface-mounted, the second BGA memories 20b1 to 20b5 being mounted on the surface of the second substrate layer 101b and not on the side of the first substrate layer 201a; and the hollow section 202, which is a space sandwiched between the first substrate layer 201a and the second substrate layer 201b and formed on the back sides of the areas where the first BGA memories 20a1 to 20a5 and the second BGA memories 20b1 to 20b5 are surface-mounted.

In order to obtain a larger volume for the hollow section 202, a cutout section may be arranged on the back sides of the areas where the BGA memory 20a and the BGA memory 20b are surface-mounted on the first rigid substrate 200a and the second rigid substrate 200b.

As described above, according to the fifth embodiment, the BGA memories are surface-mounted on two sides using the rigid substrates, and the hollow section is formed within the substrate layers of the rigid substrates corresponding to the areas where the BGA memories are surface-mounted, whereby it is possible to provide a BGA memory module with a highly reliable surface-mounting connection for a BGA memory even at a high temperature.

### [f] Sixth Embodiment

### Rigid substrate of a BGA memory module

A case is explained according to a sixth embodiment in which, in addition to the main mount pad, an auxiliary mount pad is arranged as a mount pad for a BGA memory mounted on the surface of the rigid substrate 200 according to the fifth embodiment. An explanation is given only of the parts that are different between the sixth embodiment and the fifth embodiment.

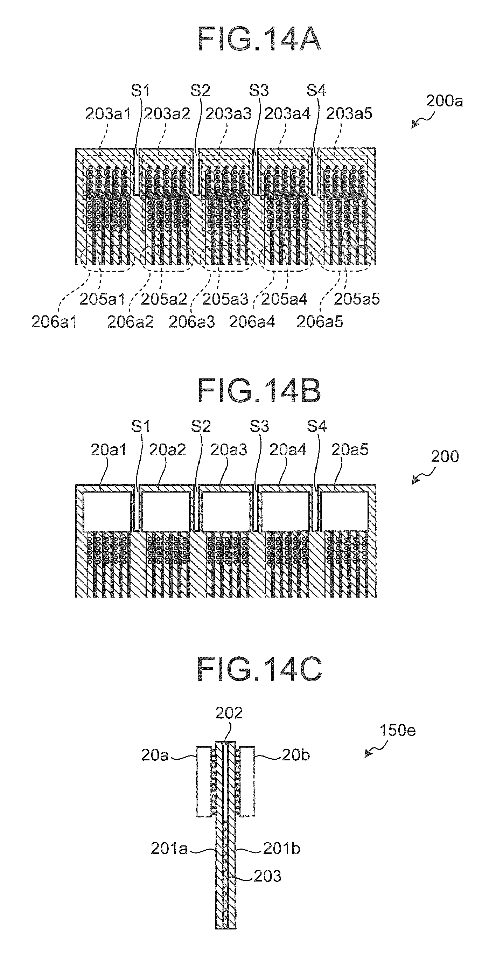

FIGS. 14A to 14E are diagrams that illustrate the outer appearance of a rigid substrate of a BGA memory module according to the sixth embodiment. FIG. 14A is a top view of a rigid substrate of a BGA memory module according to the sixth embodiment.

As illustrated in FIG. 14A, the first rigid substrate 200a includes auxiliary mount pads 205a1 to 205a5 in addition to a plurality of mount pads 203a1 to 203a5. Slits S1 to S4 are arranged in the spaces between the mount pads 203a1 to 203a5.

Wiring patterns 206a1 to 206a5 extend from the mount pads 203a1 to 203a5 and 205a1 to 205a5 to the lower sides of their respective substrate layers. The connection conditions of the mount pads 203a1 to 203a5 and the wiring patterns 206a1 to 206a5 are the same as the connection conditions of the auxiliary mount pads 205a1 to 205a5 and the wiring patterns 206a1 to 206a5.

As illustrated in FIG. 14B, the BGA memories 20a1 to 20a5 are mounted on the surfaces of the mount pads 203a1 to 203a5, respectively. The outer appearance of the first rigid substrate 200a illustrated in FIGS. 14A and 14B is the same as that of the second rigid substrate 200b.

As illustrated in the side view of a BGA memory module 150e in FIG. 14C, the first rigid substrate 200a and the second rigid substrate 200b are affixed to each other such that the BGA memories 20a1 to 20a5 and the BGA memories 20b1 to 20b5 are opposed to each other and mounted on two sides. The first rigid substrate 200a corresponds to the first substrate layer 201a, and the second rigid substrate 200b corresponds to the second substrate layer 201b.

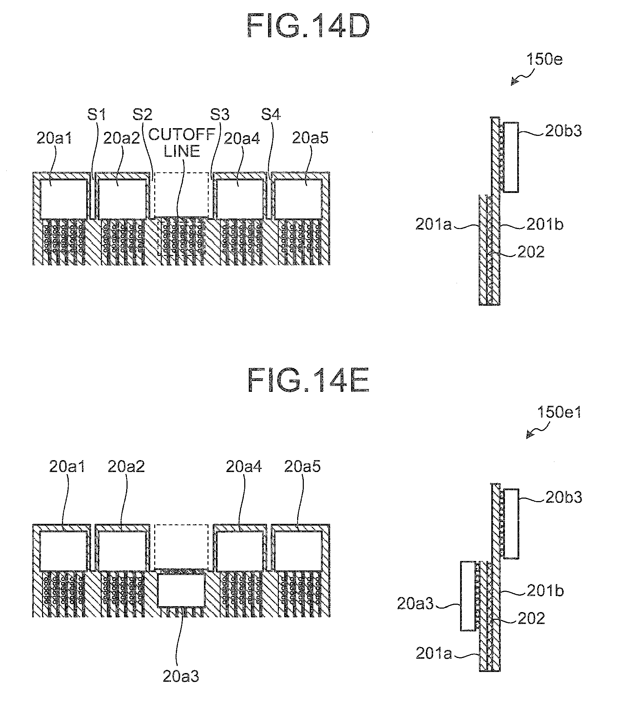

In the next case, it is assumed that a problem occurs with the surface mounting of at least one of the first BGA memory 20a and the second BGA memory 20b. FIG. 14D illustrates the case where a problem occurs with the surface mounting of the first BGA memory 20a3. In this case, as illustrated in FIG. 14D, the first substrate layer 201a is cut off at the cutoff line together with the first BGA memory 20a3. At this time, the slit S2, the slit S3, and the hollow section 202 allow only the BGA memory 20a3 to be cut off.

As illustrated in FIG. 14E, the new BGA memory 20a3 is mounted on the surface of the auxiliary mount pads 205a3. After the process of FIGS. 14D and 14E described above, a BGA memory module 150e1, which is obtained by reworking the BGA memory module 150e according to the sixth embodiment, is completed.

### Procedure for manufacturing a BGA memory module

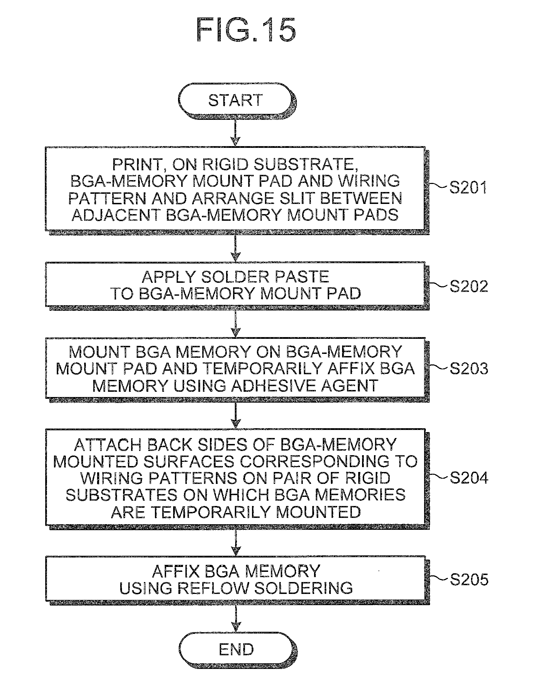

FIG. 15 is a flowchart that illustrates the procedure for manufacturing a BGA memory module according to the fifth embodiment and the sixth embodiment. The flowchart illustrates the procedure performed by, for example, an apparatus for manufacturing a BGA memory module. It may be manually performed.

First, a mount pad for a BGA memory and a wiring pattern between BGA memory slots for a mount pad and a circuit substrate are printed on a rigid substrate, and a slit is arranged between adjacent BGA memories (Step S201).

Then, solder paste is applied to the mount pad of the rigid substrate, on which the mount pad and the wiring pattern between the BGA memory slots for the mount pad and the circuit substrate have been printed at Step S201 (Step S202). Then, a BGA memory is mounted on the mount pad for a BGA memory and temporarily affixed using an adhesive agent (Step S203).

Then, the back sides of the BGA memory mounted surfaces corresponding to the wiring patterns on a pair of rigid substrates, on which the BGA memories are temporarily mounted, are attached to each other (Step S204). The BGA memory is then subjected to reflow soldering (Step S205).

As described above, according to the sixth embodiment, in the BGA memory module that is formed by affixing the rigid substrates that have a plurality of BGA memories that is surface-mounted on two sides, the hollow section is formed within the substrate layers of the rigid substrates corresponding to the areas where the BGA memories are surface-mounted, the slit is arranged between the BGA memories, and the auxiliary mount pad is arranged on the rigid substrate, whereby it is possible to provide a BGA memory module for which reworking is facilitated.

Although an example that uses an adhesive agent is illustrated in the above-described embodiments as an example of a method of fixing a BGA memory to a flexible substrate, a method of fixing a BGA memory module to a circuit substrate, and a method of fixing a flexible substrate to a BGA memory, the present invention is not limited to thereto and an adhesive tape may be used.

In an embodiment of a semiconductor device module, an electronic circuit unit, an electronic device, and a method of manufacturing a semiconductor device module according to the technology disclosed in the present application, an advantage is produced such that a reliable surface-mounting connection to a circuit substrate via solder balls or flat electrode pads is obtained even under a high-temperature atmosphere.

## Claims

1. A semiconductor device module (150a) comprising:
a first substrate layer (101a) on which a first semiconductor device (10a) is surface-mounted;
a second substrate layer (101b) that is a layer laminated on a side of the first substrate layer (101a) on which the first semiconductor device (10a) is not surface-mounted, a second semiconductor device (10b) being surface-mounted on a surface of the second substrate layer (101b) and not on a side of the first substrate layer (101a); and
a hollow section (102) that is a space sandwiched between the first substrate layer (101a) and the second substrate layer (101b) and formed on back sides of areas on which the first semiconductor device (10a) and the second semiconductor device (10b) are surface-mounted.

2. The semiconductor device module (150a) according to claim 1, wherein the first substrate layer (101a), the second substrate layer (101b), and the hollow section (102) are formed by folding a flexible substrate (100a).

3. The semiconductor device module (150a) according to claim 2, wherein
the flexible substrate (100a) includes a first mount section (104a) on which the first semiconductor device (10a) is surface-mounted and a second mount section (104b) on which the second semiconductor device (10b) is surface-mounted;
a first connection land (106a) that has a connection surface for connecting the first semiconductor device (10a) to a circuit substrate and a second connection land (106b) that has a connection surface for connecting the second semiconductor device (10b) to the circuit substrate; and
a first wiring pattern (105a) for connecting the first mount section (104a) to the first connection land (106a) and a second wiring pattern (105b) for connecting the second mount section (104b) to the second connection land (106b),
the first mount section (104a), the second mount section (104b), the first connection land (106a), the second connection land (106b), the first wiring pattern (105a), and the second wiring pattern (105b) are arranged on the same surface of the flexible substrate (100a), and
the first connection land (106a) and the second connection land (106b) are located at different distances from the first mount section (104a) and the second mount section (104b), respectively.

4. The semiconductor device module (150a) according to claim 3, wherein the flexible substrate (100a) is folded and fixed to the semiconductor device (10a, 10b) such that the connection surface faces the circuit substrate.

5. The semiconductor device module (150b) according to any one of claims 1 to 4, wherein the first connection land (112a) and the second connection land (112b) include a common connection land to be shared by the first semiconductor device (10a) and the second semiconductor device (10b).

6. The semiconductor device module (150d) according to claim 1, wherein the first substrate layer (201a), the second substrate layer (201b), and the hollow section (202) are formed by overlapping rigid substrates (200a, 200b).

7. The semiconductor device module (150e) according to claim 6, wherein a slit (S1 to S4) is arranged between mount sections of the first semiconductor devices (20a1 to 20a5) and the second semiconductor devices (20b1 to 20b5) that are mounted on two sides of the rigid substrates (200a, 200b).

8. The semiconductor device module according to any one of claims 1 to 7, wherein
the first mount section (104a) and the second mount section (104b) include a first auxiliary mount section (114a) and a second auxiliary mount section (114b), respectively, and
if a problem occurs with surface mounting of the semiconductor device (10a, 10b) on the first mount section (104a) and/or the second mount section (104b), the surface-mounted first semiconductor device (10a) and/or the surface-mounted second semiconductor device (10b) is cut off together with the first mount section (104a) and/or the second mount section (104b) so that an alternative semiconductor device (10a, 10b) can be mounted on the first auxiliary mount section (114a) and/or the second auxiliary mount section (114b).

9. An electronic circuit unit comprising a semiconductor device module (150a) as claimed in any of the preceding claims.

10. An electronic device comprising a semiconductor device module (150a) as claimed in any of claims 1 to 8.

11. A method of manufacturing a semiconductor device module (150a) comprising:
printing, on predetermined positions on a flexible substrate (100a) for each semiconductor device (10a; 10b),
a first mount section (104a) and a second mount section (104b) on which a first semiconductor device (10a) and a second semiconductor device (10b) are to be surface-mounted, respectively, a connection pad (106a, 106b) for connecting the semiconductor device (10a, 10b) to the circuit substrate, and a wiring pattern (105a, 105b) for connecting each of the first mount section (104a) and the second mount section (104b) to the connection pad;
temporarily mounting the semiconductor device (10a, 10b) on the flexible substrate (100a) by fixing, to a supporting plate (300), the flexible substrate (100a) on which the wiring pattern (105a, 105b) is printed at the printing and by applying solder paste to the mount pad;
attaching opposed areas of the flexible substrate (100a) at a position that is not a position where the semiconductor devices (10a, 10b) are opposed to each other after folding the flexible substrate (100a) at a fold line (107) set between the semiconductor devices (10a, 10b);
fixing the semiconductor device (10a, 10b) that is mounted on the mount pad at the mounting by reflow soldering; and
fixing attached areas of the flexible substrate (100a) that are attached at the attaching to the semiconductor device by folding the attached areas (108) such that a connection surface of the connection land (106a, 106b) for connecting to the circuit substrate faces the circuit substrate, wherein
the printing includes printing the connection land (106a, 106b) at a different distance from the mount pad for each of the semiconductor devices (10a, 10b).

12. The manufacturing method according to claim 11, wherein
the printing includes printing, at predetermined positions on the flexible substrate (100a), a plurality of combinations for the semiconductor devices (10a1 to 10a4) to be mounted on two sides, each combination includes the mount pad (104a, 104b), the connection pad (106a, 106b), and the wiring pattern (105a, 105b),
the manufacturing method further comprising cutting the flexible substrate (100a), to which the semiconductor devices (10a1 to 10a4) are fixed by reflow soldering at the fixing, so that each cut piece (100al to 100a4) includes the mount pad (104a, 104b), the connection pad (106a, 106b), and the wiring pattern (105a, 105b).

13. A method of manufacturing a mount component for mounting a semiconductor device (20a, 20b) on a circuit substrate, the semiconductor device (20a, 20b) being surface-mounted on two sides via a mount pad arranged in a grid pattern, the manufacturing method comprising:
printing, at predetermined positions on a rigid substrate (200a, 200b) for each semiconductor device (20a, 20b), a mount pad for mounting the semiconductor device and a socket connection pattern for connecting the semiconductor device to a socket arranged on the circuit substrate;
temporarily mounting the semiconductor device (20a, 20b) on the rigid substrate (200a, 200b) by fixing, to a supporting plate (300), the rigid substrate (200a, 200b) on which the socket connection pattern is printed at the printing and by applying solder paste to the mount pad;
attaching opposed areas of the rigid substrate (200a, 200b) at a position that is not a position where the semiconductor devices (20a, 20b) are opposed to each other; and
fixing the semiconductor device (20a, 20b) that is mounted on the mount pad at the mounting by reflow soldering.

14. The manufacturing method according to claim 13, further comprising arranging a slit (S1 to S4) between the adjacent semiconductor devices (20a1 to 20a5, 20b1 to 20b5) on the rigid substrate (200a, 200b) on which the semiconductor devices (20a1 to 20a5, 20b1 to 20b5) are fixed at the fixing.

15. A flexible substrate (100a) comprising:
a first mount section (104a) on which a first semiconductor device (10a) is surface-mounted and a second mount section (104b) on which a second semiconductor device (10b) is surface-mounted;
a first connection land (106a) that has a connection surface for connecting the first semiconductor device (10a) to a circuit substrate and a second connection land (106b) that has a connection surface for connecting the second semiconductor device (10b) to the circuit substrate; and
a first wiring pattern (105a) for connecting the first mount section (104a) to the first connection land (106a) and a second wiring pattern (105b) for connecting the second mount section (104b) to the second connection land (106b), wherein
the first mount section (104a), the second mount section (104b), the first connection land (106a), the second connection land (106b), the first wiring pattern (105a), and the second wiring pattern (105b) are arranged on the same surface of the flexible substrate (100a), and
the first connection land (106a) and the second connection land (106b) are located at different distances from the first mount section (104a) and the second mount section (104b), respectively.
